# EUROPÄISCHE PATENTANMELDUNG

(11) **EP 4 832 260 A1**
(43) Veröffentlichungstag der Anmeldung: **28.10.2026**
(21) Anmeldenummer: 26170513.1
(22) Anmeldetag: 02.04.2026
(51) Int. Cl.: H01R 13/24, G01R 15/12, G01R 15/14, G01R 15/18, H01M 50/503

(54) **ELEKTRONISCHES MESSGERÄT MIT SELBSTTOPPENDEM BATTERIEKONTAKT**

(30) Priorität: 25.04.2025 DE 102025116047
(71) Anmelder: Robert Bosch GmbH, 70442 Stuttgart (DE)
(72) Erfinder: Chan, Chi Fung, 73760 Ostfildern (DE); YING, Jianbang, Hangzhou, Zhejiang, 311400 (CN); Zhang, Xinhui, Hangzhou, 311400 (CN)

(57) **Zusammenfassung**

Die Erfindung bezieht sich auf ein elektronisches Messgerät (10) zur Messung elektrischer Größen, insbesondere von Strömen, Spannungen und ohmschen Widerständen, mit einem Batteriefach (22) zur Aufnahme einer Energiequelle (26), insbesondere mindestens einer Batterie (28) oder eines wiederaufladbaren Akkumulators oder eines Akkupacks mit mehreren wiederaufladbaren Akkumulatoren. Im Batteriefach (22) ist mindestens eine elastische Kontaktfeder (60) angeordnet, die einen elastisch auslenkbaren Abschnitt (62) aufweist, unter welchem ein insbesondere rippenförmiger Anschlag (66) verläuft.

## Beschreibung

### Technisches Gebiet

Die Erfindung bezieht sich auf ein elektronisches Messgerät zur Messung elektrischer Größen, insbesondere von Strömen, Spannungen und ohmschen Widerständen mit einem Batteriefach zur Aufnahme einer Stromquelle, insbesondere mindestens einer Batterie oder eines wiederaufladbaren Akkumulators oder Akkupacks mit mehreren wiederaufladbaren Akkumulatoren.

### Stand der Technik

DE 10 2021 122 034 A1 hat eine Vorrichtung zum elektrischen Kontaktieren von Batteriezellen zum Gegenstand. Dabei handelt es sich um ein Zellmodul mit einer Mehrzahl von elektrisch kontaktierten Batteriezellen, welche jeweils ein Gehäuse mit metallischem Gehäusebecher aufweisen, dessen Außenmantel einen ersten und dessen Gehäusedeckel einen zweiten Pol bildet. Der Gehäusebecher weist auf dem Außenmantel eine umlaufende Nut auf, von der ein Teil in einer jeweils ersten Öffnung eines als Kontaktplatte ausgebildeten Verbindungselements angeordnet ist, wobei verformtes Material um diese Öffnung des Verbindungselements die Nut bereichsweise ausfüllt, und/oder wobei wenigstens ein Teil der Nuten in einer Ringöffnung eines als metallisches Drahtelement ausgebildeten Verbindungselements um die Nut angeordnet ist. Insbesondere ist dabei das Drahtelement im Bereich der Ringöffnung in die Nut verpresst und füllt diese bereichsweise aus, wobei das Drahtelement im Bereich der Ringöffnung bevorzugt als Federelement, insbesondere als Federdraht, mit Vorspannung in die Nut eingeklipst ist und diese im Wesentlichen kraftschlüssig ausfüllt, und wobei das Drahtelement ein erstes Kontaktierungselement aufweist, das mit einer sich quer zur Längsachse erstreckenden Kontaktplatte elektrisch verbunden ist.

WO 2015 013 972 A1 betrifft eine elastische Struktur, insbesondere eine elastische Blechstruktur für einen Batterieverbinder. Diese wird als Grundplatte am Gehäuse des Batterieverbinders befestigt und ein Hauptfederarm als Kontakt mit dem Batteriepol verwendet. Der Batteriepol ist anfangs in Kontakt mit dem elastischen Kontaktteil des Hauptfederarms. Wird die Batterie gedrückt, bewegt sich dieses Kontaktteil nach unten, so dass ein Stützkontaktteil entlang des Substrats gleitet. Das elastische Kontaktteil bewegt sich zum maximalen Hub nach unten und die Seitenfläche des elastischen Hilfsarms ist parallel zum Substrat in Kontakt mit dessen Oberfläche, um einen Überspannungsschutz zu bilden. Dazu wird die elastische Kraft des Federarms stark erhöht, die elastische Verformung des elastischen Arms, die durch Überspannung verursacht wird, wird verhindert, die elastische Struktur wird geschützt, und die Zuverlässigkeit der Struktur sichergestellt. Außerdem umfasst eine elastische Batterieverbinder-Blechstruktur gemäß einer Ausführung eine Grundplatte, einen Hauptfederarm, der von einer Seite der Grundplatte schräg nach oben gebogen ist, und ein elastisches Kontaktteil auf dem Hauptfederarm, das durch dessen freies Ende gebogen und nach unten verlängert ist, um in Kontakt mit dem Batteriepol zu sein. Ein sekundärer elastischer Arm ist zur Seite des Hauptfederarms relativ zur Grundplatte geneigt und das freie Ende mit einem stützenden Kontaktabschnitt ausgebildet, der in Kontakt mit der Grundplatte ist und bei Druck daran entlang gleitet. Dabei nähert sich die Seitenfläche des sekundären elastischen Arms allmählich der Grundplatte und ist, wenn der elastische Hauptarm bis zum maximalen Hub nach unten gedrückt wird, in vollständigem Kontakt mit der Grundplatte, so dass ein Überspannungsschutz durch den elastischen Hilfsarm gebildet und die elastische Kraft der Struktur erhöht wird, um eine plastische Verformung des elastischen Arms zu verhindern.

DE 198 37 909 A1 offenbart eine Schutzvorrichtung für eine nachladbare elektrochemische Batterie mit einem Batteriegehäuse. Diese umfasst u.a. einen mehrschichtigen Aufbau, der sich von einer Kontaktplatten aufweisenden kurzen Seite eines Kontaktträgers bis zum Grund eines U-förmigen Einschnitts, der zwei Federarme trennt, erstreckt, so dass diese frei in genau vorgegebenem Abstand über einer Deckelplatte stehen. Durch die flexible Gestaltung der Federarme werden diese beim Schließen eines Schaltorgans nicht beschädigt, so dass der Schließer reversibel arbeitet: Bei abnehmendem Innendruck im Schutzgehäuse beziehungsweise zurückgehender Volumenzunahme des Batteriegehäuses nimmt das Schaltorgan wieder die Grundposition ein.

### Offenbarung der Erfindung

Erfindungsgemäß wird ein elektronisches Messgerät zur Messung elektrischer Größen, insbesondere Ströme, Spannungen und ohmsche Widerstände, vorgeschlagen, mit einem Batteriefach zur Aufnahme einer Energiequelle, insbesondere mindestens einer Batterie oder eines wiederaufladbaren Akkumulators oder eines Akkupacks mit mehreren wiederaufladbaren Akkumulatoren. Dem Batteriefach ist mindestens eine elastische Kontaktfeder zugeordnet, die einen elastisch auslenkbaren Abschnitt aufweist, unter dem ein rippenförmiger Anschlag verläuft.

Die erfindungsgemäß vorgeschlagene Lösung kann eine bleibende Deformation der Kontaktfeder, wie sie etwa bei einem unbeabsichtigten Fallenlassen des elektronischen Messgeräts durch den Bediener auftreten kann, wirksam vermieden werden, so dass ein Weiterbetrieb des elektronischen Messgerätes nach einem solchen Vorfall problemlos möglich ist.

In vorteilhafter Weiterbildung des erfindungsgemäß vorgeschlagenen elektronischen Messgerätes ist der elastisch auslenkbare Abschnitt als Federzunge ausgeführt, in welcher eine Kontaktlinie verläuft. Durch die Ausbildung des elastisch auslenkbaren Abschnitts als Federzunge können Toleranzen ausgeglichen werden, so dass auch bei Vorliegen dieser eine sichere Fixierung der mindestens einen Batterie oder eines in das Batteriefach einlegbaren, wiederaufladbaren Akkumulators oder Akkupacks sichergestellt ist.

In vorteilhafter Weiterbildung des elektronischen Messgerätes verläuft die Kontaktlinie parallel oder senkrecht zur Auslenkrichtung des elastisch anstellbaren Abschnitts.

Des Weiteren ist beim erfindungsgemäß vorgeschlagenen elektronischen Messgerät in vorteilhafter Weise vorgesehen, dass der rippenförmige Anschlag entsprechend dem Verlauf beziehungsweise der Orientierung der Kontaktlinie im Material der Kontaktfeder ausgeführt ist. Somit ist sichergestellt, dass die Kontaktlinie bei einer stoßartigen Auslenkung des elastisch auslenkbaren Abschnitts abgestützt ist und keine bleibende Deformation im Material der Kontaktfeder zurückbleibt, welche einen Weiterbetrieb des elektronischen Messgerätes verhindern würde.

Des Weiteren ist beim erfindungsgemäß vorgeschlagenen elektronischen Messgerät in vorteilhafter Weise vorgesehen, dass die Kontaktfeder als Stanz- und Biegeteil aus metallischem Material gefertigt ist.

In vorteilhafter Weiterbildung des erfindungsgemäß vorgeschlagenen elektronischen Messgerätes ist der rippenförmige Anschlag ein ausgestanzter Abschnitt einer Grundfläche der Kontaktfeder, der um einen Winkel von etwa 90° aufgestellt ist.

Schließlich zeichnet sich das erfindungsgemäß vorgeschlagene elektronische Messgerät dadurch aus, dass der elastisch auslenkbare Abschnitt an einem Federarm der Kontaktfeder ausgebildet ist. Dadurch kann der Auslenkbereich, um welchen der elastisch auslenkbare Abschnitt bewegbar ist, vergrößert werden.

In vorteilhafter Weiterbildung des erfindungsgemäß vorgeschlagenen elektronischen Messgerätes verläuft die Kontaktlinie zwischen dem elastisch auslenkbaren Abschnitt und dem Federarm.

Des Weiteren zeichnet sich das erfindungsgemäß vorgeschlagene elektronische Messgerät dadurch aus, dass der Federarm in einem Winkel zum elastisch auslenkbaren Abschnitt angeordnet ist.

Darüber hinaus ist beim erfindungsgemäß vorgeschlagenen elektronischen Messgerät vorgesehen, dass der elastisch auslenkbare Abschnitt dem insbesondere rippenförmigen Anschlag gegenüberliegend angeordnet ist.

Das erfindungsgemäß vorgeschlagene elektronische Messgerät kann als Multimeter, als Zangenamperementer, als Gabelamperemeter oder Spannungsmesser zur Messung elektrischer Größen, insbesondere von Strömen, Spannungen, ohmschen Widerständen, Kapazitäten oder Impedanzen in Gleichstrom- oder Wechselstromanwendungen ausgeführt werden. Ferner kann das elektronische Messgerät ein Entfernungsmesser, ein Feuchtigkeitsmesser mit einer stabförmig oder einer flächig ausgebildeten Messeinrichtung oder ein Hygrometer oder dergleichen sein.

### Vorteile der Erfindung

Durch die erfindungsgemäß vorgeschlagene Ausbildung des elektronischen Messgerätes, insbesondere der im Batteriefach vorgesehenen, mindestens einen Kontaktfeder, ist sichergestellt, dass bei stoßartigen Impulsen, die auf die Kontaktfeder wirken können, etwa beim Herunterfallen des elektronischen Messgerätes aus der Hand des Bedieners, eine bleibende plastische Deformation der Kontaktfeder unterbleibt. Dies kann beispielsweise dann auftreten, wenn beispielsweise beim Handhaben des elektronischen Messgerätes durch den Bediener, ohne dass Batterien im Batteriefach untergebracht sind, dieses aus dessen Hand rutscht und auf einem harten Untergrund aufschlägt. Durch den erfindungsgemäß unter dem elastisch auslenkbaren Abschnitt der Kontaktfeder vorgesehenen rippenförmigen Anschlag wird eine bleibende Deformation des elastisch auslenkbaren Abschnitts verhindert, so dass nach einem derartigen Vorfall eine Wiederinbetriebnahme bei eingelegten Batterien oder wiederaufladbarem Akkumulator oder Akkupack ein Weiterbetrieb des elektronischen Messgerätes möglich ist.

In vorteilhafter Weise ist der insbesondere rippenförmige Anschlag der insbesondere als Stanz- oder Biegeteil aus metallischem Material gefertigten Kontaktfeder so beschaffen, dass diese aus einer Grundfläche mittels eines Stanz- und Biegeprozesses gestanzt und aufgebogen ist. Dabei lässt sich der insbesondere rippenförmige Anschlag unterhalb des elastisch auslenkbaren Abschnitts, insbesondere einer Federzunge der Kontaktfeder, in einer Höhe anordnen, die eine begrenzte elastische Verformung des elastisch auslenkbaren Abschnitts zulässt, jedoch so gewählt ist, dass eine zu starke Verformung des elastisch auslenkbaren Abschnitts, d. h. der Federzunge der Kontaktfeder, unterbleibt. Die erfindungsgemäß vorgeschlagene, im Batteriefach angeordnete, mindestens eine Kontaktfeder kann insbesondere als Stanz- und Biegeteil ausgebildet werden, so dass bei deren Fertigung der besagte, insbesondere rippenförmige Anschlag in einem Arbeitsgang ausgebildet werden kann.

In vorteilhafter Weise kann der insbesondere rippenförmige Anschlag, der eine dauerhafte plastische Deformation des elastisch auslenkbaren Abschnitts verhindert, so angebracht werden, dass dieser komplementär zu einer Orientierung einer Kontaktlinie an dem elastisch auslenkbaren Abschnitt verläuft. Die Kontaktlinie am elastisch auslenkbaren Abschnitt kann parallel zum insbesondere rippen oder stegförmig ausgeführten Anschlag verlaufen. Der Anschlag selbst kann im metallischen Material der Kontaktfeder stegförmig, nach Art eines Vorsprungs oder eines Stempels, oder auch rippenförmig ausgeführt sein.

### Kurze Beschreibung der Zeichnungen

Ausführungsformen der Erfindung werden anhand der Zeichnungen und der nachfolgenden Beschreibung näher erläutert.

Es zeigen:
- Figur 1: eine perspektivische Ansicht eines elektronischen Messgerätes,
- Figur 2: eine Darstellung eines Teils eines Batteriefachs eines elektronischen Messgerätes,
- Figur 3: eine perspektivische Ansicht einer Gehäuserückseite eines elektronischen Messgerätes mit geöffnetem Batteriefach,
- Figur 4: eine perspektivische Darstellung der erfindungsgemäß vorgeschlagenen Kontaktfeder,
- Figur 5: die erfindungsgemäß vorgeschlagene Kontaktfeder im in das Gehäuse des elektronischen Messgerätes eingebauten Zustand,
- Figur 6: eine perspektivische Ansicht der mit einer Leiterplattenanordnung verbundenen Kontaktfeder und
- Figur 7: eine Darstellung einer Einbausituation der Kontaktfeder in das Gehäuse des elektronischen Messgerätes neben einem Batteriefach.

### Ausführungsformen der Erfindung

In der nachfolgenden Beschreibung der Ausführungsformen der Erfindung werden gleiche oder ähnliche Elemente mit gleichen Bezugszeichen bezeichnet, wobei auf eine wiederholte Beschreibung dieser Elemente in Einzelfällen verzichtet wird. Die Figuren stellen den Gegenstand der Erfindung nur schematisch dar.

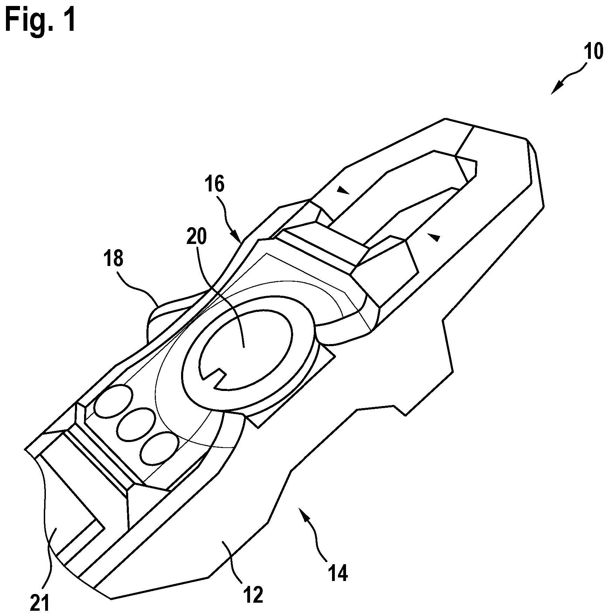

Der perspektivischen Ansicht gemäß Figur 1 ist ein elektronisches Messgerät 10 zu entnehmen, welches ein Gehäuse 12 umfasst, welches eine Gehäuserückseite 14 sowie eine Gehäusevorderseite 16 umfasst. Seitlich am Gehäuse 12 des elektronischen Messgerätes 10 befindet sich ein Auslöser 18 zum Auslösen einer Messung. Des Weiteren befindet sich auf der Gehäusevorderseite 16 des Gehäuses 12 ein verdrehbarer Wahlschalter 20, mit welchem unterschiedliche Betriebsmodi des elektronischen Messgerätes 10 eingestellt werden können. Mit diesem können beispielsweise elektrische Größen, wie Ströme, Spannungen, ohmsche Widerstände, Impedanzen, Kapazitäten und dergleichen gemessen werden. Das elektronische Messgerät 10 kann aber auch ein Feuchtigkeitsmessgerät, ein Entfernungsmesser oder ein Hygrometer oder dergleichen sein.

Auf der Gehäusevorderseite 16 des Gehäuses 12 des elektronischen Messgerätes 10 befindet sich darüber hinaus ein Display 21, welches in Figur 1 nur teilweise darstellt ist. Das Gehäuse 12 des elektronischen Messgerätes 10 gemäß der Darstellung in Figur 1 ist so bemessen, dass dieses von Hand bedient werden kann und angenehm in der Hand des Bedieners liegt. Dementsprechend ergonomisch ist das Gehäuse 12 des elektronischen Messgerätes 10 geformt.

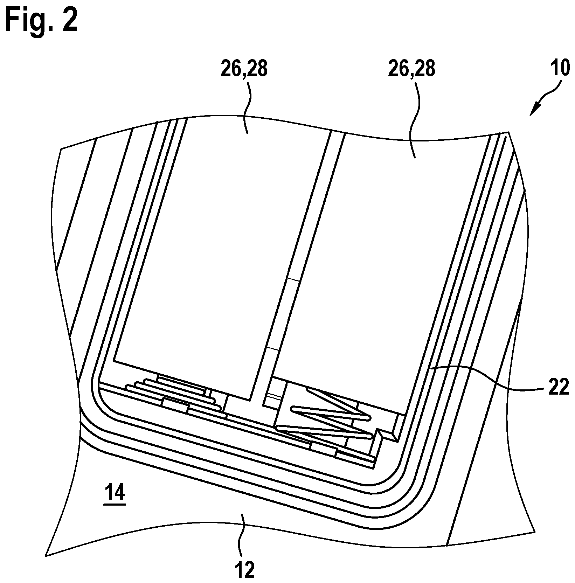

Figur 2 ist eine teilweise Darstellung eines elektronischen Messgeräts 10 zu entnehmen, in dessen Gehäuse 12 ein Batteriefach 22 ausgebildet ist. Das sich an einer Gehäuserückseite 14 des Gehäuses 12 befindende Batteriefach 22 nimmt in der Darstellung gemäß Figur 2 zwei Batterien 28 auf, bei denen es sich um Alkaline-Batterien handelt. Alternativ besteht die Möglichkeit, im Batteriefach 22 des elektronischen Messgerätes 10 gemäß der perspektivischen Darstellung in Figur 2 als Energiequelle 26 einen wiederaufladbaren Lithium-Ionen-Akkumulator oder einen Akkupack mit mehreren wiederaufladbaren Akkumulatoren aufzunehmen. Aus der Darstellung gemäß Figur 2 geht hervor, dass die beiden in das Batteriefach 22 eingelassenen Batterien 28 durch Spiralfedern fixiert sind, wobei eine der beiden Batterien 28 im Batteriefach 22 mittels eines rippenförmigen Vorsprungs im Batteriefach 22 gesichert ist.

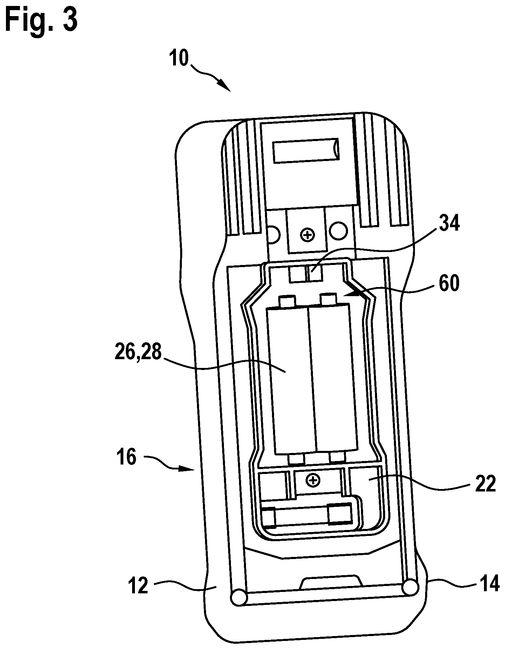

Figur 3 ist eine perspektivische Ansicht einer Gehäuserückseite 14 des elektronischen Messgeräts 10 mit einem entfernten Batteriefachdeckel 24 zu entnehmen.

Aus der perspektivischen Darstellung gemäß Figur 3 geht hervor, dass das Batteriefach 22 als Energiequelle 26 zwei Alkaline-Batterien 28 aufnimmt. Diese werden mittels mindestens einer in das Batteriefach 22 eingelassenen Kontaktfeder 60 im Batteriefach 22 elektrisch leitend kontaktiert. Aus der Darstellung gemäß Figur 3 geht ferner hervor, dass das Batteriefach 22 von einer Fassung umschlossen ist sowie einen beispielsweise am oberen Ende des Batteriefachs 22 in dieses eingelassenen Trennschalter 34 aufweist. Der Trennschalter 34 wird durch ein in Figur 3 nicht näher dargestelltes Betätigungselement 36 eines ebenfalls in Figur 3 nicht dargestellten Batteriefachdeckels 24 betätigt.

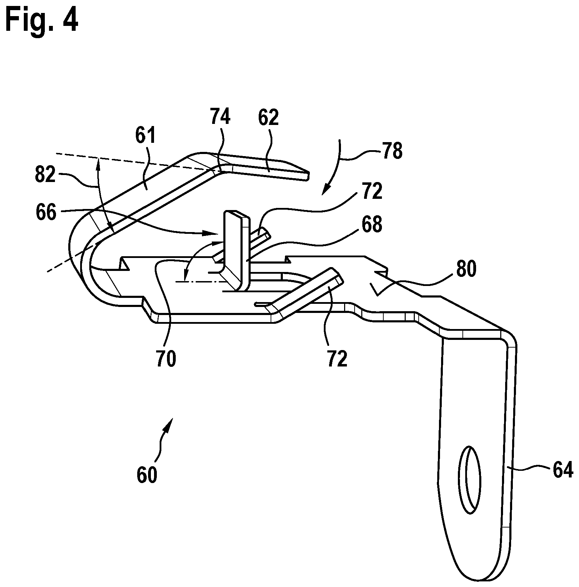

Figur 4 zeigt eine perspektivische Ansicht der elastischen Kontaktfeder 60, die in das Batteriefach 22 im Gehäuse 12 des elektronischen Messgerätes 10 eingelassen ist.

Bei der Kontaktfeder 60 handelt es sich um ein aus einem metallischen Material gefertigtes Stanz- und Biegeteil, welches, bezogen auf eine Grundfläche 80 einen über eine ca. 180°-Biegung mit diesem verbundenen elastisch auslenkbaren Abschnitt 62 umfasst, der als Federzunge bezeichnet werden kann. Am anderen Ende der Grundfläche 80 der Kontaktfeder 60 verläuft eine hier abgewinkelt ausgebildete Federlasche 64. In der Grundfläche 80 der elastischen Kontaktfeder 60 aus metallischem Material ist ein rippenförmiger Anschlag 66 ausgestanzt. Dieser wird bei der Herstellung der elastischen Kontaktfeder 60 aus dem Material der Grundfläche 80 ausgestanzt und durch einen Biegeprozess in eine 90°-Aufstellung 70 verbracht. Der rippenförmig ausgebildete Anschlag 66 in seiner 90°-Aufstellung 70 gemäß der Darstellung in Figur 4 ist in der Grundfläche 80 so angeordnet, dass die Oberseite des rippenförmigen federnden Anschlags 66 unterhalb einer Kontaktlinie 74 im elastisch auslenkbaren Abschnitt 62, d. h. der Federzunge liegt. Bei einer stoßartigen Verformung der Kontaktfeder 60 ist somit eine dauerhafte plastische Verformung des auslenkbaren Abschnitts 62 verhindert, da dieser beispielsweise bei einer Stoßbeanspruchung auf die Oberseite des in 90°-Aufstellung 70 angeordneten rippenförmigen Anschlags 66 auftrifft und keine plastische Verformung annimmt, die einen Weiterbetrieb des elektronischen Messgerätes 10 aufgrund einer verformten Kontaktfeder 60 verhindern würde.

Aus der Darstellung gemäß Figur 4 geht hervor, dass in dieser Ausführungsvariante der Kontaktfeder 60 aus metallischem Material der rippenförmige Anschlag 66 parallel zur Kontaktlinie 74 am elastisch auslenkbaren Abschnitt 62 verläuft. Alternativ besteht die Möglichkeit, den rippenförmigen Anschlag 66 aus der Grundfläche 80 der elastischen Kontaktfeder 60 so auszugestalten, dass dieser auch unterhalb einer um 90° verdrehten Kontaktlinie 74 im elastisch auslenkbaren Abschnitt 62 verläuft, mithin komplementär zur Orientierung der Kontaktlinie 74 ausgebildet sein kann.

Neben dem hier in einer 90°-Aufstellung 70 dargestellten, elastisch auslenkbaren Abschnitt 62 sind aus der Grundfläche 80 der elastischen Kontaktfeder 60 parallel zueinander Biegelaschen 72 aufgestellt. Diese können in dem in der perspektivischen Darstellung gemäß Figur 3 dargestellten 30°-Winkel ausgebildet sein oder auch eine andere Winkelorientierung in Bezug auf die hier in horizontaler Orientierung dargestellte Grundfläche 80 aufweisen.

Der rippenförmige Anschlag 66 gemäß der Darstellung in Figur 4 ist in dieser Darstellung in einer 90°-Aufstellung 70 gezeigt, wobei auch andere Winkel der Kontaktfeder 60 in Bezug auf die Anstellung des rippenförmigen Anschlags 66, bezogen auf die Grundfläche 80, möglich sind. Der rippenförmige Anschlag 66 kann neben einer rippenförmigen Ausbildung auch in Form eines Steges, nach Art eines Vorsprungs oder eines Stempels oder dergleichen, ausgeführt sein. In besonders günstiger Weise ist der rippenförmige Anschlag 66 im Material der Kontaktfeder 60 so ausgebildet, dass dieser der Kontaktlinie 74 direkt zugeordnet ist, d. h. parallel unter dieser oder senkrecht zu dieser, je nach dem, wie die Kontaktlinie 74 im elastisch auslenkbaren Abschnitt 62 ausgebildet ist, verläuft. Des Weiteren ist hervorzuheben, dass die Kontaktfeder 60 einen Federarm 61 aufweist. Der Federarm 61 verläuft im elastisch auslenkbaren Abschnitt 62 aus, so dass dessen Auslenkbewegung in Richtung des in Figur 4 dargestellten Pfeils 78 vergrößert wird. Insbesondere ist der Federarm 61 im Material der Kontaktfeder 60 so ausgebildet, dass dieser einen Winkel 82 in Bezug auf den elastisch auslenkbaren Abschnitt 62 bildet.

Der Darstellung gemäß Figur 4 ist ferner eine Auslenkrichtung 78 des elastisch auslenkbaren Abschnitts 62 der Kontaktfeder 60 zu entnehmen. Der rippenförmige Anschlag 66 ist in der Grundfläche 80 der elastischen Kontaktfeder 60 derart positioniert, dass durch dessen Höhe eine plastische Deformation des elastisch auslenkbaren Abschnitts 62, d. h. der Federzunge der Kontaktfeder 60, ausgeschlossen ist. Die Höhe des rippenförmigen Anschlags 66 ist so bemessen, dass eine bestimmte Deformation, d. h. Bewegung des elastisch auslenkbaren Abschnitts 62 der Kontaktfeder 60 in Bezug auf den Kopf des rippenförmigen Anschlags 66 zugelassen ist, jedoch eine weitergehende, zu einer plastischen Deformation führende Verformung durch den rippenförmigen Anschlag 66 ausgeschlossen wird.

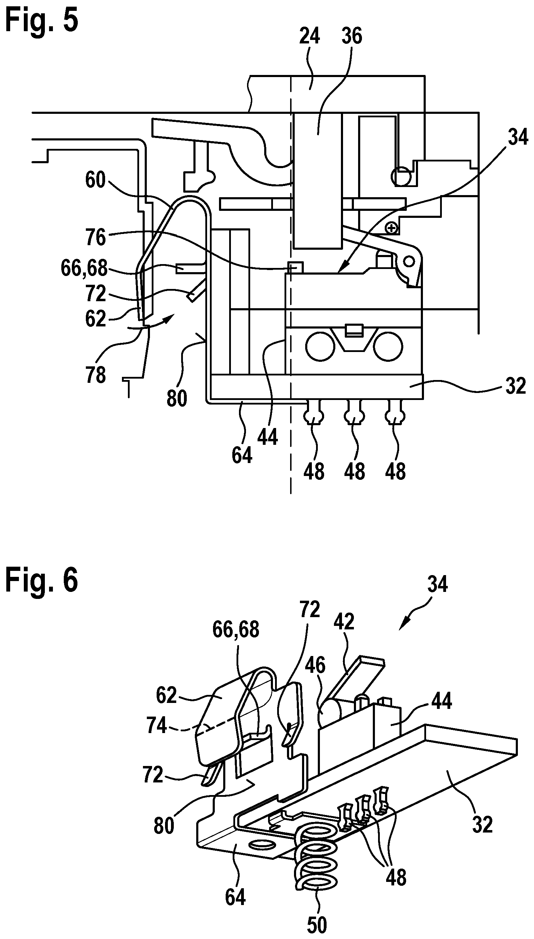

Der Darstellung gemäß Figur 5 ist eine beispielhaft dargestellte Einbauposition der elastischen Kontaktfeder 60 zu entnehmen. Diese ist mit ihrer Federlasche 64 an der Unterseite einer Leiterplattenanordnung 32 befestigt. In der Seitenansicht gemäß Figur 5 sind einerseits der rippenförmige Anschlag 66, ausgebildet als in die Zeichenebene verlaufende Rippe, dargestellt sowie die beidseits vom rippenförmigen Anschlag 66 in der Grundfläche 80 der elastischen Kontaktfeder 60 herausgestanzten Biegelaschen 72, die beispielsweise einen Winkel von 30° zur hier in vertikaler Einbaulage dargestellten Grundfläche 80 aufweisen.

Der Darstellung gemäß Figur 5 ist ein Teil eines Schalterkörpers 44 des in Figur 2 in seiner Einbauposition in das Batteriefach 22 dargestellten Trennschalters 34 zu entnehmen. An der Oberseite des Schalterkörpers 44 befindet sich eine Kontaktstelle 76.

Die Darstellung gemäß Figur 5 gibt eine Seitenansicht der in Figur 3 in perspektivischer Ansicht dargestellten elastischen Kontaktfeder 60 aus metallischem Material wieder. Der Einbaulage der elastischen Kontaktfeder 60 gemäß Figur 5 lässt sich entnehmen, dass deren elastisch auslenkbarer Abschnitt 62 Toleranzen in horizontaler Richtung auszugleichen in der Lage ist. Der Abstand zwischen der Kontaktlinie 74 einerseits und dem Kopf des rippenförmigen Anschlags 66 definiert den zulässigen Auslenkweg in Auslenkrichtung 78 des elastisch auslenkbaren Abschnitts 62, ohne dass dieser eine plastische Deformation erfährt und damit einen Weiterbetrieb des elektronischen Messgerätes 10 unmöglich machen würde.

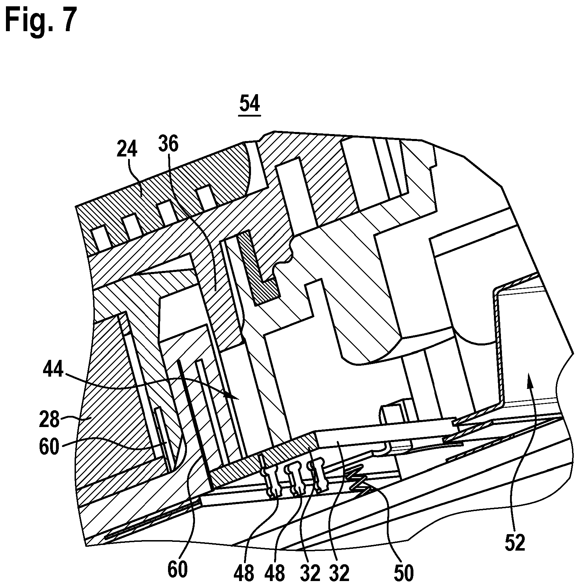

Den Figuren 6 und 7 ist zu entnehmen, dass die elastische Kontaktfeder 60 an der Leiterplattenanordnung 32 aufgenommen ist. An deren Unterseite sind mehrere Kontaktstifte 48 vorgesehen sowie eine Anstellfeder 50, mit deren Hilfe die Anordnung aus Leiterplattenanordnung 32 und mit dieser verbundener elastischer Kontaktfeder 60 gegen einen Vorsprung oder eine Anlagefläche im Inneren des Gehäuses 12 des elektronischen Messgerätes 10 angestellt wird. Aus der perspektivischen Ansicht gemäß Figur 6 geht hervor, dass beidseits des rippenförmigen Anschlags 66 besagte Biegelaschen 72 aus der Grundfläche der elastischen Kontaktfeder 60 ausgestanzt sind. Die Federlasche 64 verläuft in der Darstellung gemäß Figur 6 parallel zur Unterseite der Leiterplattenanordnung 32.

Figur 7 ist zu entnehmen, dass in der Einbaulage der Kontaktfeder 60 diese mit der Unterseite der Leiterplattenanordnung 32 verbunden ist und mit ihrem in Figur 5 dargestellten elastisch auslenkbaren Abschnitt 62 die im Batteriefach 22 angeordneten Batterien 28 fixiert. Das Batteriefach 22 ist durch einen Batteriefachdeckel 24 verschlossen, an dem sich das bereits erwähnte Betätigungselement 36 in Stift- oder Stabform befindet, welches den in den Boden des Batteriefachs 22 angeordneten Trennschalter 34 im montierten Zustand des Batteriefachdeckels 24 auf dem Batteriefach 22 kontaktiert und damit die Strom- beziehungsweise Spannungsversorgung des elektronischen Messgerätes 10 freigibt.

Die Erfindung ist nicht auf die hier beschriebenen Ausführungsbeispiele und die darin hervorgehobenen Aspekte beschränkt. Vielmehr ist innerhalb des durch die Ansprüche angegebenen Bereichs eine Vielzahl von Abwandlungen möglich, die im Rahmen fachmännischen Handelns liegen.

## Patentansprüche

1. Elektronisches Messgerät (10) zur Messung elektrischer Größen, insbesondere von Strömen, Spannungen und ohmschen Widerständen, mit einem Batteriefach (22) zur Aufnahme einer Energiequelle (26), insbesondere mindestens einer Batterie (28) oder eines wiederaufladbaren Akkumulators oder eines Akkupacks mit mehreren wiederaufladbaren Akkumulatoren, **dadurch gekennzeichnet, dass** dem Batteriefach (22) mindestens eine elastische Kontaktfeder (60) zugeordnet ist, die einen elastisch auslenkbaren Abschnitt (62) aufweist, unter dem ein insbesondere rippenförmiger Anschlag (66) verläuft.

2. Elektronisches Messgerät (10) gemäß Anspruch 1, **dadurch gekennzeichnet, dass** der elastisch auslenkbare Abschnitt (62) als Federzunge ausgeführt ist, in welcher eine Kontaktlinie (74) verläuft.

3. Elektronisches Messgerät (10) gemäß den Ansprüchen 1 bis 2, **dadurch gekennzeichnet, dass** die Kontaktlinie (74) parallel oder senkrecht zu einer Auslenkrichtung (78) des elastisch auslenkbaren Abschnitts (62) verläuft.

4. Elektronisches Messgerät (10) gemäß Anspruch 3, **dadurch gekennzeichnet, dass** der insbesondere rippenförmige Anschlag (66) entsprechend der Orientierung der Kontaktlinie (74) im Material der Kontaktfeder (60) ausgeführt ist.

5. Elektronisches Messgerät (10) gemäß den Ansprüchen 1 bis 4, **dadurch gekennzeichnet, dass** die Kontaktfeder (60) als Stanz- und Biegeteil aus metallischem Material gefertigt ist.

6. Elektronisches Messgerät (10) gemäß den Ansprüchen 1 bis 5, **dadurch gekennzeichnet, dass** der insbesondere rippenförmige Anschlag (66) ein ausgestanzter Abschnitt einer Grundfläche (80) der Kontaktfeder (60) ist, der um einen Winkel von im Wesentlichen 90° (70) aufgestellt ist.

7. Elektronisches Messgerät (10) gemäß den Ansprüchen 1 bis 6, **dadurch gekennzeichnet, dass** der elastisch auslenkbare Abschnitt (62) an einem Federarm (61) der Kontaktfeder (60) ausgeführt ist.

8. Elektronisches Messgerät (10) gemäß den Ansprüchen 1 bis 7, **dadurch gekennzeichnet, dass** die Kontaktlinie (74) zwischen dem elastisch auslenkbaren Abschnitt (62) und dem Federarm (61) verläuft.

9. Elektronisches Messgerät (10) gemäß den Ansprüchen 1 bis 8, **dadurch gekennzeichnet, dass** der Federarm (61) in einem Winkel (82) zum elastisch auslenkbaren Abschnitt (62) angeordnet ist.

10. Elektronisches Messgerät (10) gemäß den Ansprüchen 1 bis 9, **dadurch gekennzeichnet, dass** der elastisch auslenkbare Abschnitt (62) dem insbesondere rippenförmigen Anschlag gegenüberliegend angeordnet ist.

11. Elektronisches Messgerät (10) gemäß einem der Ansprüche 1 bis 10, **dadurch gekennzeichnet, dass** dieses als Multimeter, als Zangenameremeter, als Gabelamperemeter oder als Spannungsmesser zur Messung elektrischer Größen, insbesondere Ströme, Spannungen, ohmsche Widerstände, Kapazitäten oder Impedanzen, in Gleichstrom oder Wechselstromanwendungen ausgeführt ist, ferner als Hygrometer, Feuchtigkeitsmesser oder Entfernungsmesser.
